# EUROPÄISCHE PATENTSCHRIFT

(11) **EP 1 358 490 B1**
(45) Veröffentlichungstag und Bekanntmachung des Hinweises auf die Patenterteilung: **07.09.2005**
(21) Anmeldenummer: 02704630.9
(22) Anmeldetag: 06.02.2002
(51) Int. Cl.: G01R 15/14, G08C 19/00, G01R 19/252, G01R 19/00

(54) **VERFAHREN ZUR AUSWERTUNG EINES MESSSIGNALS UND ZUGEHÖRIGE SCHALTUNGSANORDNUNG**
METHOD FOR EVALUATING A MEASURING SIGNAL AND CORRESPONDING CIRCUIT ARRANGEMENT
PROCEDE POUR EVALUER UN SIGNAL DE MESURE ET ENSEMBLE CIRCUIT CORRESPONDANT

(30) Priorität: 09.02.2001 DE 10105982
(43) Veröffentlichungstag der Anmeldung: 05.11.2003
(73) Patentinhaber: SIEMENS AKTIENGESELLSCHAFT, 80333 München (DE)
(72) Erfinder: RUPP, Jürgen, 91056 Erlangen (DE)
(86) Internationale Anmeldenummer: PCT/DE2002/000433
(87) Internationale Veröffentlichungsnummer: WO 2002/065142

(56) Entgegenhaltungen:
- DE-A- 19 910 755
- DE-C- 19 711 218
- FR-A- 2 541 777
- US-A- 6 114 947

## Beschreibung

Die Erfindung bezieht sich auf ein Verfahren zur Auswertung eines Messwertes gemäß dem Oberbegriff des Patentanspruches 1. Daneben bezieht sich die Erfindung auch auf die zugehörige Schaltungsanordnung zur Durchführung des Verfahrens, zwecks Anwendung bei der Strommessung an einem Shunt, bei dem der Spannungsabfall als Maß für den Strom ausgewertet wird.

Speziell zur Strommessung ist es üblich, einen sog. Shunt, der im Wesentlichen aus einem definierten Widerstand besteht, zu benutzen und den Spannungsabfall an diesem Widerstand als Stromwert anzugeben. Häufig liegt ein solcher Shunt auf gegenüber Erdpotential höheren Potential.

Eine Strommessung an einem auf Potential liegenden Shunt ist bekannt. Der Baustein LM 3822 der Fa. National Semiconductor liefert zur Strommessung nach Analog/Digitalwandlung ein PWM-Signal (s. Internet www.Power.National.com).

Wenn ein derartiger Shunt auf hohem Potential liegt, ist zur Weiterverarbeitung der Messsignale meist eine galvanische Trennung vorgeschrieben. Dafür werden beispielsweise Optokoppler verwendet. Da der Spannungsabfall meist durch Operationsverstärker od. dgl. verstärkt wird, ist weiterhin eine Hilfsstromversorgung zumindest für den Verstärker notwendig. In der Praxis muss also dafür ein nicht zu vernachlässigender Aufwand für die Hilfsstromversorgung einerseits und für die spannungsmäßige Entkopplung andererseits getrieben werden.

Aus der DE 199 10 755 A1 ist eine lineare Strommessschältung speziell für eine Motorschaltung bekannt, bei der eine auf Hochspannung liegende Eingangsschaltung mit einem Verstärker und einem A/D-Wandler ein Digitalsignal mit einer Folge von Stromimpulsen liefert, die auf Erdpotential in ein Analogsignal zurückgewandelt werden.

Weiterhin ist.aus der FR 2 541 777 A eine Vorrichtung zur transformatorischen Signalübertragung zwischen einem Primärteil im Niederspannungsbereich und einem Sekundärteil im Hochspannungsbereich bekannt, bei der im Primärteil eine Stromversorgung vorhanden ist, die die zur Funktion des Sekundärteils erforderliche Energie transformatorisch in Form von Leistungsimpulsen vom Primärteil zum Sekundärteil überträgt. Dabei erfolgt die Informationsübertragung durch das Tastverhältnis der periodischen Leistungsimpulspausen.

Ausgehend vom Stand der Technik ist es Aufgabe der Erfindung, den technischen Aufwand für eine Strommessung auf Potential zu minimieren.

Die Aufgabe ist bei einem Verfahren der eingangs genannten Art durch die Merkmale des Patentanspruches 1 gelöst. Eine zugehörige Schaltungsanordnung speziell zur Strommessung an einem Shunt ist im Patentanspruch 7 angegeben. Vorteilhafte Weiterbildungen des Verfahrens und der zugehörigen Anordnung sind Gegenstand der jeweils abhängigen Ansprüche.

Bei der Erfindung wird der auf hohem Potential anfallende Messwert durch die Modulation der eigenen Stromversorgung, die auf Hochspannungspotential liegt, auf Erdpotential übertragen. Die Stromversorgung der Erfassung für das Messsignal und die Übertragung des Messwertes werden somit kombiniert. Die bisher noch notwendige galvanische Trennung kann dann entfallen. Insbesondere mit dieser Maßnahme ist die erfindungsgemäße Lösung gegenüber der Vorgehensweise des Standes der Technik kostengünstiger.

Durch die Erfindung ist eine gleichzeitige Nutzung der Stromversorgung der Einheit für die Datenübertragung durch Modulation des Versorgungsstromes erreicht. Damit ist es möglich, die Messung auf hohem Potential durchzuführen und den Messwert als modulierten Versorgungsstrom zu übertragen.

Die Erfindung eignet sich insbesondere zur Strommessung mittels eines auf Potential liegenden Shunts. Aber auch für andere Messaufgaben, bei denen beliebige Messwerte auf höherem Potential liegen, ist die Erfindung anwendbar.

Weitere Einzelheiten und Vorteile der Erfindung ergeben sich aus der nachfolgenden Figurenbeschreibung anhand der Zeichnung in Verbindung mit den Patentansprüchen. Es zeigen
- Figur 1: das Prinzip einer Strommessungseinrichtung, bei der die Messwerte durch Modulation der eigenen Stromversorgung übertragen werden,
- Figur 2: eine Abwandlung von Figur 1 mit differentieller Modulation.

Gleiche Einheiten haben in den Figuren gleiche Bezugszeichen. Die Figuren werden teilweise gemeinsam beschrieben.

In den Figuren ist mit L1 eine Phase einer auf Potential liegenden Leitung bezeichnet. N bezeichnet den Neutralleiter auf Erdpotential. An L1 und N ist ein Verbraucher 10 angeschlossen. Gleichermaßen können zwei weitere Phasen L2 und L3 vorhanden sein.

In der auf Potential liegenden Leitung L1 ist ein Shunt 1 mit Widerstandswert Rₛ eingeschaltet. Am Shunt 1 wird die Spannung U1 abgegriffen und einem Verstärker 2 zugeführt. Dem Verstärker 2 folgt ein Analog/Digital(A/D)-Wandler 3, der ein Digitalsignal ausgibt.

Das Digitalsignal des A/D-Wandlers 3 wird als Modulationstakt für eine Modulationseinheit 4 verwendet, die gleichermaßen zur Stromversorgung der Einheiten 2 und 3 dient. Zur Bereitstellung eines Versorgungsstromes ist die Modulationseinheit 4 mit den spannungsführenden Leitungen, d.h. mit dem Phasenleiter L1 und dem Neutralleiter N, verbunden.

Von der Modulationseinheit 4 wird nunmehr der Versorgungsstrom moduliert und über Widerstände 6 und 7 mit Widerstandswerten Rᵥ und Rₘ auf den Neutralleiter N mit Erdpotential geleitet. Die Widerstände 6 und 7 dienen als Spannungsteiler, wobei über den Widerstand 7 ein Abzweig auf eine Auswerteeinheit 5, die auf Erdpotential liegt, geleitet wird. Die Auswerteeinheit 5 ist beispielsweise ein Mikrocontroller, über den der Messwert ausgegeben wird.

In der Modulationseinheit 4 kann die Modulation des Versorgungsstromes beispielsweise durch eine Ein/Aus-Tastung erfolgen. Dafür sind beispielsweise ein erster Schalter 41 und ein zweiter Schalter 42 vorhanden, die zweckmäßigerweise als Halbleiterschalter ausgebildet sind. Die beiden Schalter S1 und S2 werden gegenphasig geöffnet und geschlossen, wobei die Betätigungsfrequenz vom Wert des zu übertragenden Messsignals abhängt. In der Modulationseinheit 4 ist für diesen Zweck eine Schaltersteuerung 40 vorhanden, die vom A/D-Wandler 3 angesteuert wird und die gegenphasig Schaltersignale an die Schalter 41 und 42 abgibt.

Die Auswertung des Messwertes besteht aus einer Frequenzmessung des Modulationstaktes. Das Taktsignal wird über den Spannungsabfall des mit der Messinformation modulierten Versorgungsstromes über den Widerstand 7, der einen definierten Widerstandswert R_{M} hat, zurückgewonnen. Damit steht ein Signal mit dem ursprünglichen Messwert zur Verfügung.

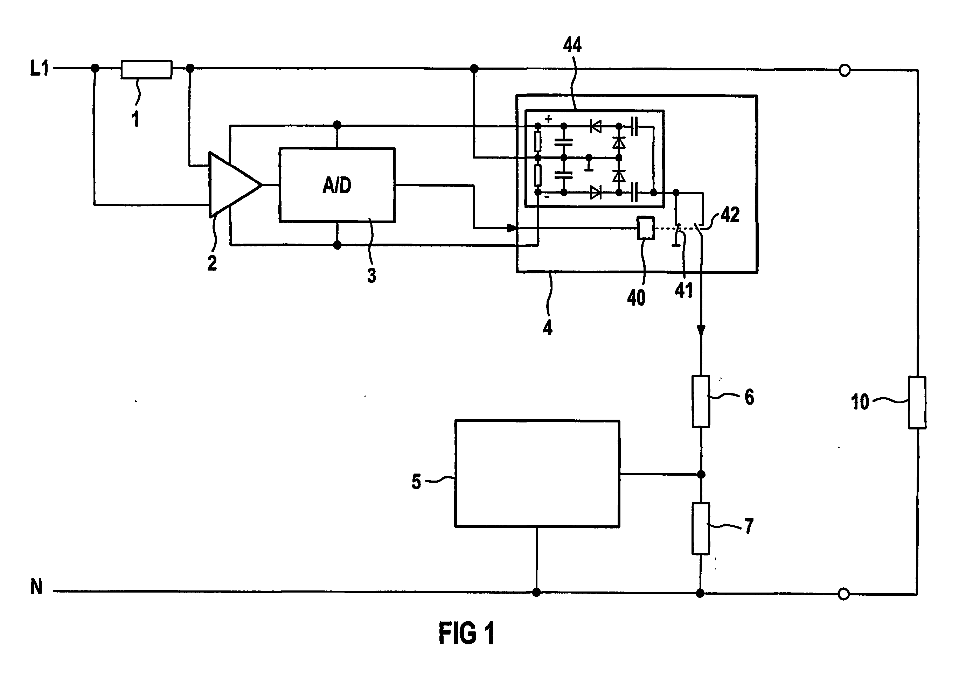

Die Modulationseinheit 4 enthält weiterhin eine Stromversorgungseinheit 44 mit einer Gleichrichterschaltung. Über die Gleichrichterschaltung, die in der Figur 1 symbolhaft angedeutet ist, wird ein Hilfsstrom gewonnen, der die auf Potential liegenden Komponenten, wie insbesondere den Verstärker 2 und den A/D-Wandler 3 mit Strom versorgt.

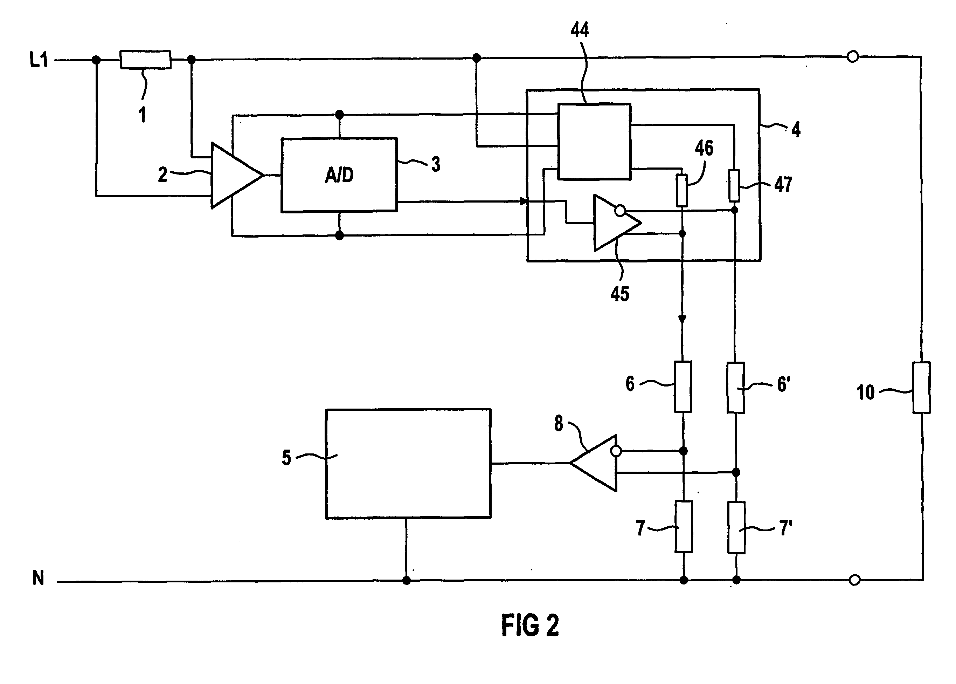

In Figur 2 ist die Anordnung gemäß Figur 1 zur differentiellen Modulation der Messsignale abgewandelt. Dazu sind zwei Spannungsteiler aus den Widerständen 6, 7 bzw. 6', 7' mit jeweiligen Widerstandswerten Rᵥ₁, Rₘ₁ und Rᵥ₂, Rₘ₂ vorhanden, von denen ein Differenzwert über einen Differenzverstärker 8 auf die Auswerteeinheit 5 gegeben wird. angesteuert werden. Die Modulationsfunktion bleibt ansonsten aber gleich.

Bei dem anhand der beiden Ausführungsbeispiele beschriebenen Schaltungen erfolgt eine gleichzeitige Nutzung der Stromversorgung als Einheit für die Datenübertragung durch die Modulation des Versorgungsstromes. Damit ist es in einfacher Weise möglich, die Messung auf hohem Potential durchzuführen und den Messwert zur Messwertausgabe zu übertragen.

Das beschriebene Verfahren eignet sich sowohl für Gleich- als auch Wechselstromnetze, insbesondere auch Drehstromnetze. Neben der Anwendung bei der Strommessung sind auch andere Anwendungen möglich, beispielsweise Temperaturmessungen bei auf Potential liegenden Einrichtungen. Solche Einrichtungen sind beispielsweise bei Kraftfahrzeugen vorhanden, bei denen der eine Pol eines Verbraucher mittels intelligenter Schalter an die positive Versorgungsspannung geschaltet werden, während der andere Pol auf Masse liegt. Neben dem Strom werden dabei auch Informationen über die Temperatur übertragen.

## Patentansprüche

1. Verfahren zur Auswertung eines Messsignals, das auf gegenüber Nullpotential höherem Potential in einer Messeinrichtung, die einen Versorgungsstrom benötigt, als Analogwert anfällt und dessen Messinformation nach einer A/D-Wandlung als Digitalsignal zu einer auf Erdpotential liegenden Auswerteeinheit übertragen wird, **dadurch gekennzeichnet, dass** nach der A/D-Wandlung des Messsignals das erzeugte Digitalsignal den Takt für eine Modulation des Versorgungsstromes, der somit gleichermaßen die Funktion des Trägers für den Informationsgehalt des Messsignals erfüllt, liefert, wobei der Versorgungsstrom direkt aus der aufgegenüber Nullpotential höherem Potential liegenden Leitung entnommen wird.

2. Verfahren nach Anspruch 1, **dadurch gekennzeichnet, dass** zwei Teilstrompfade des Versorgungsstromes gegenphasig moduliert werden.

3. Verfahren nach Anspruch 1, **dadurch gekennzeichnet, dass** die Modulationsfrequenz vom Wert des zu übertragenden Messsignals abhängt.

4. Verfahren nach Anspruch 3, **dadurch gekennzeichnet, dass** das Messsignal binär als Zahlenwert übertragen wird.

5. Verfahren nach einem der vorhergehenden Ansprüche, **dadurch gekennzeichnet, dass** zur Auswertung des Messsignals eine Frequenz- oder Periodendauermessung des mit der Messinformation modulierten Versorgungsstromes erfolgt.

6. Verfahren nach Anspruch 5, **dadurch gekennzeichnet, dass** zur Auswertung des modulierten Versorgungsstromes der Takt des im A/D-Wandler erzeugten Digitalsignals zurückgewonnen wird.

7. Schaltungsanordnung zur Durchführung des Verfahrens nach Anspruch 1 oder einem der Ansprüche 2 bis 6, zwecks Anwendung bei der Strommessung an einem Shunt, bei dem der Spannungsabfall als Maß für den Strom nach Verstärkung ausgewertet wird, mit einem Shunt (1), einem Verstärker (2) für das am Shunt (1) abgegriffene Spannungssignal, einem Analog/Digital-Wandler (3) und einer Modulationseinheit (4) zur Stromversorgung der Messkomponenten, insbesondere des Verstärkers (2) und des A/D-Wandlers (3), wobei die Modulationseinheit (4) eine Stromversorgungseinheit (44) für die Messkomponenten (2, 3) aufweist und auf Hochspannungspotential liegt.

8. Schaltungsanordnung nach Anspruch 7, **dadurch gekennzeichnet, dass** für den modulierten Versorgungsstrom wenigstens ein Widerstand (7, 7') mit einer diesem zugeordneten, auf Erdpotential liegenden Auswerteeinheit (5) vorhanden ist.

9. Schaltungsanordnung nach Anspruch 8, **dadurch gekennzeichnet, dass** dem wenigstens einen Widerstand (7) mindestens ein weiterer Widerstand (6) zugeordnet ist, wobei die beiden Widerstände (6, 7) mit ihren definierten Widerstandswerten (Rᵥ, Rₘ) als Spannungsteiler wirken.

10. Schaltungsanordnung nach Anspruch 9, **dadurch gekennzeichnet, dass** zur differentiellen Modulation zwei Widerstände (7, 7') mit definierten Widerstandswerten (Rₘ₁, Rₘ₂) und zwei weitere Widerstände (6, 6') mit definierten Widerstandswerten (Rᵥ₁, Rᵥ₂) als zwei Spannungsteiler vorhanden sind.

11. Schaltungsanordnung nach Anspruch 9 oder Anspruch 10, **dadurch gekennzeichnet, dass** die an den Spannungsteilern (6, 7; 6', 7') abgegriffenen Spannungen über einen Differenzverstärker (8) auf die Auswerteeinheit (5) gegeben werden.

12. Schaltungsanordnung nach Anspruch 7, **dadurch gekennzeichnet, dass** die Modulationseinheit (4) zwei gegenphasig arbeitende Schalter (41, 42) mit einer zugehörigen Schaltersteuerung (40) aufweist.

13. Schaltungsanordnung nach Anspruch 7, **dadurch gekennzeichnet, dass** die Modulationseinheit (4) Widerstände (46, 47) aufweist, die von einem Modulationsverstärker (45) angesteuert werden.

## Claims

1. Method for evaluation of a measurement signal, which is in the form of an analogue value at a potential higher than zero potential in a measurement device which requires a supply current, and whose measurement information is transmitted after A/D conversion as a digital signal to an evaluation unit which is at ground potential, **characterised in that**, after the A/D conversion of the measurement signal, the digital signal which is produced provides the clock for modulation of the supply current, which thus at the same time carries out the function of the carrier for the information content of the measurement signal, with the supply current being drawn directly from the conductor at a potential higher than zero potential.

2. Method according to claim 1, **characterised in that** two current path elements of the supply current are modulated in antiphase.

3. Method according to claim 1, **characterised in that** the modulation frequency depends on the value of the measurement signal to be transmitted.

4. Method according to claim 3, **characterised in that** the measurement signal is transmitted in binary form, as a numerical value.

5. Method according to one of the preceding claims, **characterised in that** a frequency or period duration measurement of the supply current which is modulated with the measurement information is carried out for evaluation of the measurement signal.

6. Method according to claim 5, **characterised in that** the clock of the digital signal which is produced in the A/D converter is recovered for evaluation of the modulated supply current.

7. Circuit arrangement for carrying out the method according to claim 1 or one of claims 2 to 6, for use with a current measurement on a shunt, in which the voltage drop is evaluated as a measure of the current after amplification, having a shunt (1), having an amplifier (2) for the voltage signal which is tapped off across the shunt (1), having an analogue/digital converter (3), and having modulation unit (4) for supplying current to the measuring components, in particular the amplifier (2) and the A/D converter (3), with the modulation unit (4) having a power supply unit (44) for the measurement components (2, 3) and being at a high-voltage potential.

8. Circuit arrangement according to claim 7, **characterised in that** in the at least one resistor (7, 7') together with an evaluation unit (5) which is associated with it and is at ground potential are provided for the modulated supply current.

9. Circuit arrangement according to claim 8, **characterised in that** the at least one resistor (7) has at least one further associated resistor (6) with the defined resistance values (R_{*v*1}, R_{*m*1}) of the two resistors (6,7) acting as a voltage divider.

10. Circuit arrangement according to claim 9, **characterised in that** two resistors 7, 7' with defined resistance values (R_{*v*1}, R_{*m*1}) and two further resistors (6, 6') with defined resistance values (R_{*v*2}, R_{*m*2}) are provided as two voltage dividers for differential modulation.

11. Circuit arrangement according to claim 9 or claim 10, **characterised in that** the voltages which are tapped off on the voltage dividers (6, 7; 6', 7') are passed via a differential amplifier (8) to the evaluation unit (5).

12. Circuit arrangement according to claim 7, **characterised in that** the modulation unit (4) has two switches (41, 42) which operate in antiphase and have an associated switch controller (40).

13. Circuit arrangement according to claim 7, **characterised in that** the modulation unit (4) has resistors (46, 47) which are driven by a modulation amplifier (45).

## Revendications

1. Procédé d'exploitation d'un signal de mesure qui est généré sous la forme d'une valeur analogique à un potentiel supérieur au potentiel zéro dans un dispositif de mesure, qui nécessite une alimentation en courant, et dont l'information de mesure est transmise après une conversion A/N sous la forme d'un signal numérique à une unité d'exploitation se trouvant au potentiel de la terre, **caractérisé en ce que**, après la conversion A/N du signal de mesure, le signal numérique généré délivre l'horloge destinée à une modulation du courant d'alimentation qui a en même temps la fonction de porteuse du contenu informationnel du signal de mesure, le courant d'alimentation étant pris directement de la ligne se trouvant à un potentiel plus élevé que le potentiel zéro.

2. Procédé selon la revendication 1, **caractérisé en ce que** deux chemins de courant partiels du courant d'alimentation sont modulés en opposition de phase.

3. Procédé selon la revendication 1, **caractérisé en ce que** la fréquence de modulation dépend de la valeur du signal de mesure à transmettre.

4. Procédé selon la revendication 3, **caractérisé en ce que** le signal de mesure est transmis sous forme binaire comme valeur numérique.

5. Procédé selon l'une des revendications précédentes, **caractérisé en ce que**, pour exploiter le signal de mesure, il est effectué une mesure de la période ou de la fréquence du courant d'alimentation modulé par l'information de mesure.

6. Procédé selon la revendication 5, **caractérisé en ce que**, pour exploiter le courant d'alimentation modulé, l'on récupère l'horloge du signal numérique généré dans le convertisseur A/N.

7. Agencement de circuits destiné à mettre en oeuvre le procédé selon la revendication 1 ou l'une des revendications 2 à 6, en vue de l'application lors de la mesure d'un courant à un shunt au niveau duquel la chute de tension est exploitée comme mesure du courant après amplification, lequel agencement de circuit comporte un shunt (1), un amplificateur (2) destiné au signal de tension prélevé au niveau du shunt (1), un convertisseur analogique/numérique (3) et une unité de modulation (4) destinée à l'alimentation en courant des composants de mesure, en particulier l'amplificateur (2) et le convertisseur A/N (3), l'unité de modulation comportant une unité d'alimentation en courant (44) destinée aux composants de mesure (2, 3) et se trouvant au potentiel le plus élevé.

8. Agencement de circuits selon la revendication 7, **caractérisé en ce qu'**il est prévu pour le courant d'alimentation modulé au moins une résistance (7, 7') à laquelle est associée une unité d'exploitation (5) se trouvant au potentiel de la terre.

9. Agencement de circuits selon la revendication 8, **caractérisé en ce que** au moins une autre résistance (6) est associée à la au moins une résistance (7), les deux résistances (6, 7) de valeurs définies (Rᵥ et Rₘ) servant de diviseurs de tension.

10. Agencement de circuits selon la revendication 9, **caractérisé en ce que** deux résistances (7, 7') de valeurs définies (Rₘ₁ et Rₘ₂) et deux autre résistances (6, 6') de valeurs définies (Rᵥ₁ et Rᵥ₂) servent de deuxième diviseur de tension pour la modulation différentielle.

11. Agencement de circuit selon la revendication 9 ou la revendication 10, **caractérisé en ce que** les tensions prélevées au niveau des diviseurs de tension (6, 7 ; 6', 7') sont transmises à l'unité d'exploitation (5) par l'intermédiaire d'un amplificateur différentiel (8).

12. Agencement de circuits selon la revendication 7, **caractérisé en ce que** l'unité de modulation (4) comportent deux interrupteurs (41, 42) qui fonctionnent en opposition de phase et auxquels est associée une commande d'interrupteur (40).

13. Agencement de circuits selon la revendication 7, **caractérisé en ce que** l'unité de modulation (4) comportent des résistances (46, 47) qui sont attaquées par un amplificateur de modulation (45).
